Europäisches Patentamt

(19) European Patent Office

Office européen des brevets

(11) Publication number : **0 461 908 A2**

# (12) EUROPEAN PATENT APPLICATION

(21) Application number : **91305376.5**

(22) Date of filing : **13.06.91**

(51) Int. Cl.⁵ : **H01L 31/18, H01L 31/0224**

(30) Priority : **14.06.90 JP 156040/90**

(43) Date of publication of application :
**18.12.91 Bulletin 91/51**

(84) Designated Contracting States :
**DE FR GB**

(71) Applicant : **FUJITSU LIMITED**
**1015, Kamikodanaka Nakahara-ku**
**Kawasaki-shi Kanagawa 211 (JP)**

(72) Inventor : **Miyagaki, Shinji**
**Rozugaden 103, 1-15-3 Fukasawa**
**Setagaya-ku, Tokyo 158 (JP)**
Inventor : **Morishita, Kenji**
**54-10 Shiratoridai, Midori-ku**
**Yokohama-shi, Kanagawa 227 (JP)**
Inventor : **Ri, Seigen**
**Bamhaitsu Kikuna 5-302, 1-30 Kaminomiya**
**Tsurumi-ku, Yokohama-shi, Kanagawa 230**
**(JP)**

(74) Representative : **Rackham, Stephen Neil et al**
**GILL JENNINGS & EVERY 53-64 Chancery**
**Lane**
**London WC2A 1HN (GB)**

(54) **Process for preparing a transparent electrode and transparent electrode prepared by it.**

㊳ A transparent electrode is prepared by a process, comprising the steps of depositing a transparent layer of indium tin oxide or indium oxide on a substrate, the transparent layer essentially consisting of a crystalline phase having a crystal orientation of (222) and/or (400) only, optionally with an amorphous phase, and patterning the deposited transparent indium tin oxide or indium oxide layer. Practical and controllable etching of an ITO or $In_2O_3$ layer having a thickness of 150 nm in about 5 to 7 minutes, for example, is thus possible by selecting such crystal orientations.

EP 0 461 908 A2

The present invention relates to a process for preparing a transparent electrode and a transparent electrode prepared thereby. More specifically, it relates to a process for preparing a transparent electrode of ITO (Indium Tin Oxide) or indium oxide ($In_2O_3$).

Transparent electrodes are used as a light incident side electrode of a light receiving element such as a CCD camera or as a display side electrode of a liquid crystal display device, etc., and, are formed by depositing a transparent conductive layer of ITO or $IN_2O_3$, followed by patterning the layer by photolithography.

Generally, a transparent conductive layer of ITO or $In_2O_3$ is deposited by sputtering, and the properties of the deposited layer are remarkably varied depending on the sputtering power, gas pressure, substrate temperature, and atmospheric gas, etc. Although the varied properties of the transparent conductive layer cause variations of an etching rate of the transparent conductive layer, since the factors that determine the optimum etching rate are not known, in practice the patterning of a transparent conductive layer of ITO or $In_2O_3$ is sometimes impossible or results in a deformation of the pattern or a severe permeation of the enchant under a resist mask, thereby reducing the yield.

The object of the present invention is to provide a process for preparing a transparent electrode in which a desired pattern is reproducibly formed at an optimum etching rate.

According to a first aspect of this invention a process for preparing a transparent electrode, comprising the steps of

depositing a transparent layer of indium tin oxide or indium oxide on a substrate, and pattering the deposited transparent indium tin oxide or indium oxide layer,

is characterised in that the transparent layer essentially consists of a crystalline phase having a crystal orientation of (222) and/or (400), only optionally with an amorphous phase.

According to a second aspect of this invention a transparent electrode comprises a transparent electrode made of indium tin oxide or indium oxide, composed essentially of a crystalline phase having a crystal orientation of (222) and/or (400) only, optionally with an amorphous phase.

A particular embodiment of a process and an electrode in accordance with this invention will now be described with reference to the accompanying drawings; in which:-

Figure 1 is a schematic view of a sputtering apparatus for depositing a transparent conductive layer,

Figure 2 is a schematic view of an etching of the transparent conductive layer, and

Figure 3 shows the X-ray diffraction patterns of ITO layers.

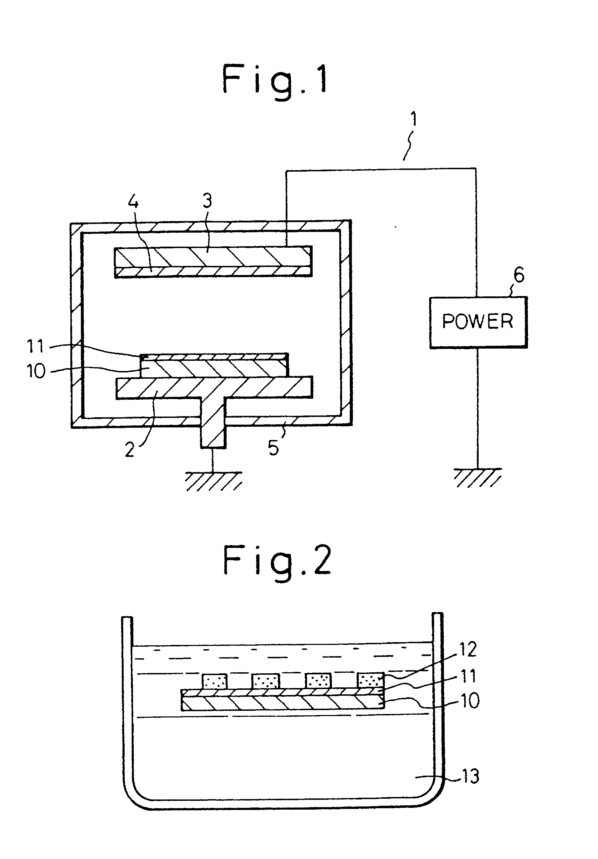

Figure 1 shows a magnetron sputtering apparatus for depositing a transparent conductive layer, wherein a substrate 10 is mounted on a substrate electrode 2, a target 4 is attached to a target electrode 3, and a chamber 5 is then evacuated. Thereafter, argon gas is introduced into the chamber 5 and a voltage is applied between the electrodes 2 and 3.

The sputtering power is either a high frequency or a direct current, and the pressure in the chamber 5 and the substrate temperature are varied as shown in Table 1.

An ITO layer 11 was deposited on the substrate 10, and the thickness of the layers was fixed to 150 nm.

The deposited ITO layer was analyzed by an X-ray diffraction, and the results are shown in Table 1. The crystal orientation is the orientation on the surface of the deposited layer, i.e., in the direction vertical to the surface of the deposited layer.

## TABLE 1

| Sputtering Power | Pressure (Torr) | Substrate Temperature (°C) | Crystallinity |
|---|---|---|---|
|  |  | 150 | (222) |
| RF | $5\times10^{-3}$ | 180 | (222) |
| 13.56MHz |  | 200 | (222) and (400) |
| 200 W | $3\times10^{-3}$ | 120 | (222), (400) and (411) |
|  |  | 100 | (222), (400) and (321) |
|  |  | 120 | (222), (400) and (321) |
| Direct current | $5\times10^{-3}$ | 150 | (222), (400) (321), (411) and (420) |
|  |  | 200 | (400), (222) and (411) |

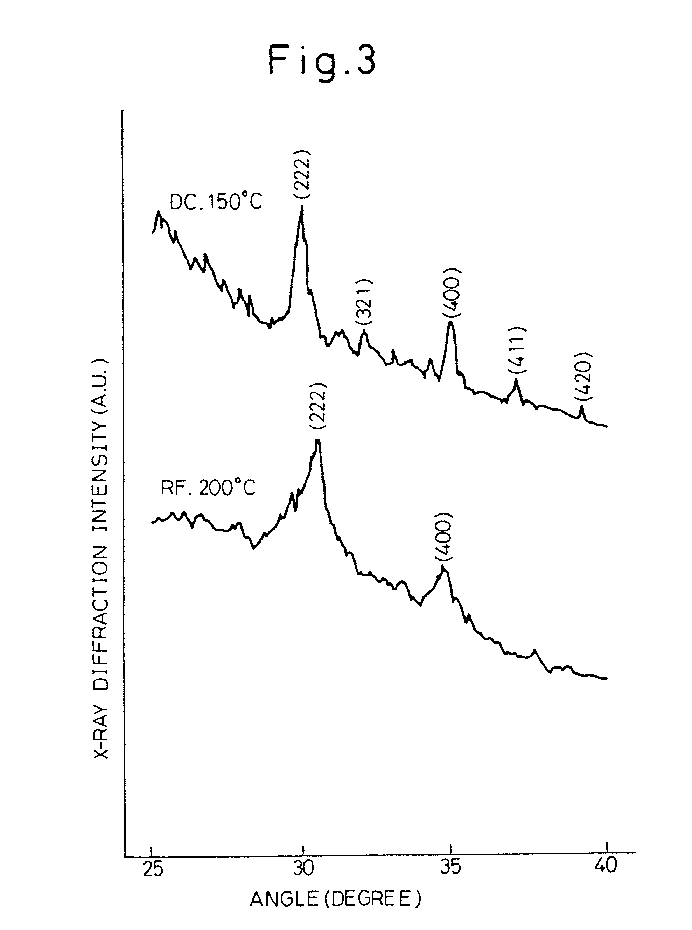

Figure 3 shows X-ray patterns obtained by RF at 200°C and by DC at 150°C, as examples. In Fig. 3, the X-ray pattern obtained by an RF at 200°C indicates (222) and (400) orientations with no other orientation and the X-ray pattern obtained by a DC at 150°C indicates (222), (400), (321), (411) and (420) orientations. These orientations are those of indium oxide and no crystallinity of tin oxide was observed. This is considered to be because the content of tin oxide was small, about 10% by weight.

It is seen from Table 1 that the ITO layers deposited by a RF power were a polycrystalline layer with (222) orientation only, a polycrystalline layer with (222) and (400) orientations only, or a polycrystalline layer with (222), (400) and (411) orientations. The ITO layers deposited by a direct current power were a polycrystalline layer with orientations of not only (222) and (400) but also (321), (411), (420), etc. Table 1 suggest that on RF sputtering at a temperature of not lower than 150°C is preferable.

The ITO layers thus formed on the substrate 10 were then patterned by a wet etching, as shown in Figure 2. The ITO layer 11 was covered with a patterned resist mask 12 and immersed for example, in a 35%-aqueous solution 13 of iron chloride ($FeCl_3$) at 40°C.

The results are shown in Table 2.

## TABLE 2

| Crystallinity | Etching rate by FeCl₃ (nm/min) |
|---|---|
| (222) only | 20 to 30 |
| (222) and (400) only | |
| not only (222) and (400) but also (321), (411), (420), etc. | 0 (not etched after 60 min) |

As apparent from Table 2, the etching rate of a polycrystalline ITO layer with only (222) and/or (400) orientations was 20 to 30 nm/min, and therefore, a stable etching was obtained and a desired pattern was formed in this layer. Namely, a practical and controllable etching of an ITO layer having a thickness of 150 nm in 5 to about 7 minutes was made possible.

In contrast, when the other ITO layers were immersed in the aqueous solution of iron chloride for 60 minutes, very little etching occurred, and thus it was found that an etching of these layers is not practical.

It was also confirmed that an ITO layer comprised of a mixture phase of a crystalline phase with (222) and/or (400) orientation only and an amorphous phase can be etched at a practical and controllable etching rate.

Although an aqueous solution of iron chloride was used as an etchant, other etchants such as hydrochloric acid or a hydrochloric acid-nitric acid-water mixture, etc., also may be used.

Although the above Examples are directed to an ITO layer, it is apparent that similar results can be obtained with respect to an indium oxide layer instead of an ITO layer, because the content of tin oxide in an ITO layer as a transparent conductive layer is very small and an etching rate of ITO is little changed by the existence of such a small content of tin oxide.

## Claims

1. A process for preparing a transparent electrode, comprising the steps of
   depositing a transparent layer of indium tin oxide or indium oxide on a substrate, and pattering the deposited transparent indium tin oxide or indium oxide layer,
   characterised in that the transparent layer essentially consists of a crystalline phase having a crystal orientation of (222) and/or (400) only, optionally with an amorphous phase.

2. A process according to claim 1, wherein the transparent indium tin oxide or indium oxide layer contains an amorphous phase.

3. A process according to claim 1 or 2, wherein the transparent indium tin oxide or indium oxide layer is deposited by sputtering.

4. A process according to claim 3, wherein the transparent indium tin oxide or indium oxide layer is deposited at a temperature of not lower than 150°C.

5. A process according to claim 3 or 4, wherein the sputtering is an RF sputtering.

6. A process according to any one of the preceding claims, wherein the patterning of the transparent indium tin oxide or indium oxide layer is performed by wet etching with an enchant consisting of iron chloride, hydrochloric acid, or a hydrochloric acid/nitric acid mixture.

7. A transparent electrode made of indium tin oxide or indium oxide, composed essentially of a crystalline phase having a crystal orientation of (222) and/or (400) only, optionally with an amorphous phase.

8. A transparent electrode according to claim 7, which contains an amorphous phase.

9. A method according to any one of claims 1 to 6 or a transparent electrode according to claim 7 or 8, in which the electrode is an electrode of a light receiving element.

10. A method according to any one of claims 1 to 6 or a transparent electrode according to claim 7 or 8, in which the electrode is an electrode of a liquid crystal display device.

# Fig.1

POWER

# Fig.2

# Fig.3